# EUROPÄISCHE PATENTSCHRIFT

(11) **EP 3 555 969 B1**
(45) Veröffentlichungstag und Bekanntmachung des Hinweises auf die Patenterteilung: **18.01.2023**
(21) Anmeldenummer: 17787181.1
(22) Anmeldetag: 20.10.2017
(51) Int. Cl.: H01R 13/504, H01R 13/52, H01R 43/18, H01R 12/72, H01R 13/405, H05K 3/28

(54) **GETRIEBESTEUERUNGSEINRICHTUNG, INSBESONDERE FÜR EIN KRAFTFAHRZEUG, UND VERFAHREN ZUM HERSTELLEN EINES STECKERGEHÄUSES**
TRANSMISSION CONTROL DEVICE, IN PARTICULAR FOR A MOTOR VEHICLE, AND METHOD FOR PRODUCING AN ELECTRICAL-CONNECTOR HOUSING
DISPOSITIF DE COMMANDE DE TRANSMISSION, NOTAMMENT POUR UN VÉHICULE À MOTEUR, ET PROCÉDÉ DE FABRICATION D'UN BOÎTIER DE CONNEXION

(30) Priorität: 13.12.2016 DE 102016224795
(43) Veröffentlichungstag der Anmeldung: 23.10.2019
(73) Patentinhaber: Robert Bosch GmbH, 70442 Stuttgart (DE)
(72) Erfinder: HOEFER, Michael, 07629 Reichenbach (DE)
(86) Internationale Anmeldenummer: PCT/EP2017/076859
(87) Internationale Veröffentlichungsnummer: WO 2018/108364

(56) Entgegenhaltungen:
- EP-A1- 1 575 344
- EP-A1- 1 672 972
- EP-A1- 2 953 210
- WO-A2-2013/167588
- DE-A1-102008 043 774
- DE-A1-102013 206 256
- DE-A1-102013 209 296
- DE-A1-102015 203 592
- JP-A- 2010 067 773

## Beschreibung

### Gebiet der Erfindung

Die Erfindung betrifft eine Getriebesteuerungseinrichtung, insbesondere für ein Kraftfahrzeug, und ein Verfahren zum Herstellen eines Steckergehäuses.

### Stand der Technik

Getriebesteuerungseinrichtungen, insbesondere für Kraftfahrzeug, müssen über Steckverbinder bzw. Steckergehäuse mit Verbindungssteckern zur Signalübertragung, die elektrisch mit dem Leiterplattenelement verbunden werden sollen, verbunden werden. Getriebesteuerungseinrichtungen werden bzw. sind oft in einer Ölumgebung angeordnet. Daher muss die Verbindung zwischen dem Steckverbinder bzw. dem Steckergehäuse und dem Leiterplattenelement der Getriebesteuerungseinrichtung bzw. den Leiterbahnen üblicherweise öldicht ausgebildet sein.

Hierfür wird oftmals ein Steckergehäuse mit einem Stecker auf Basis von gestanzten Leiterbahnen verwendet. Gegebenenfalls werden die Leiterbahnen bzw. das thermoplastische Material um die Leiterbahnen anschließend vergossen.

Nachteilig an bisher bekannten Getriebesteuerungseinrichtungen ist, dass der Herstellungsprozess in der Regel technisch aufwendig ist. In der Regel wird zur Herstellung des Steckergehäuses bzw. der Getriebesteuerungseinrichtung mit Steckergehäuse eine Vielzahl unterschiedlicher Werkzeuge benötigt. Dies führt üblicherweise zu hohen Herstellungskosten. Zudem ist unter ungünstigsten Umständen der Bereich zwischen dem Steckergehäuse und dem Leiterplattenelement der Getriebesteuerungseinrichtung nicht über die gesamte Lebensdauer des Kraftfahrzeugs sicher öldicht sein.

### Offenbarung der Erfindung

### Vorteile der Erfindung

Ausführungsformen der vorliegenden Erfindung können in vorteilhafter Weise ermöglichen, eine dauerhafte bzw. sehr langlebige öldichte Verbindung zwischen dem Steckergehäuse und dem Leiterplattenelement der Getriebesteuerungseinrichtung bereitzustellen.

Gemäß einem ersten Aspekt der Erfindung wird eine Getriebesteuerungseinrichtung nach Anspruch 1, insbesondere für ein Kraftfahrzeug, vorgeschlagen, wobei die Getriebesteuerungseinrichtung folgendes umfasst: ein Leiterplattenelement mit elektronischen Bauelementen, und ein Steckergehäuse zum Aufnehmen eines Verbindungsteckers und zum elektrischen Verbinden des Verbindungsteckers mit dem Leiterplattenelement, dadurch gekennzeichnet, dass das Steckergehäuse im Wesentlichen aus Duroplastmaterial besteht, wobei das Steckergehäuse das Leiterplattenelement in unmittelbarem Kontakt stoffschlüssig teilweise umschließt.

Ein Vorteil hiervon ist, dass die Getriebesteuerungseinrichtung in der Regel technisch einfach herstellbar ist. Zudem ist üblicherweise die Verbindung zwischen dem Steckergehäuse und dem Leiterplattenelement dauerhaft bzw. über einen sehr langen Zeitraum (z.B. mehr als 20 Jahre oder mehr als 25 Jahre) öldicht. Darüber hinaus werden im Allgemeinen zur Herstellung der Getriebesteuerungseinrichtung nur ein Werkzeug bzw. eine geringe Anzahl von Werkzeugen benötigt. Insbesondere werden in der Regel keine Stanzwerkzeuge und/oder Vorumspritzwerkzeuge benötigt. Hierdurch sind die Herstellungskosten in der Regel gering.

Duroplastmaterial kann insbesondere ein Kunststoff sein, der nach seiner Aushärtung durch Erwärmung oder andere Maßnahmen nicht mehr verformt werden kann. Zwischen dem Duroplastmaterial und dem Leiterplattenelement ist kein Kleber oder ähnliches angeordnet, sondern das Duroplastmaterial bildet direkt bzw. unmittelbar mit der Außenoberfläche des Leiterplattenelements eine stoffschlüssige Verbindung. Duroplastmaterialien werden üblicherweise auch Duromere genannt. Insbesondere kann in der Regel das Duroplastmaterial Epoxidharz, Chitin, Harnstoff-Formaldehydharz, Melamin-Formaldehydharz, Phenol-Formaldehydharz, Polyester, Polyurethan und/oder ungesättigter Polyester sein.

Gemäß einem zweiten Aspekt der Erfindung wird ein Verfahren nach Anspruch 4 zum Herstellen eines Steckergehäuses an einem Leiterplattenelement einer Getriebesteuerungseinrichtung, insbesondere für ein Kraftfahrzeug, vorgeschlagen, wobei das Steckergehäuse zum Aufnehmen eines Verbindungssteckers und zum elektrischen Verbinden des Verbindungsteckers mit dem Leiterplattenelement ausgebildet ist, wobei das Verfahren folgende Schritte umfasst: Bereitstellen des Leiterplattenelements; Aufbringen eines Duroplastmaterials unmittelbar auf einen Teil des Leiterplattenelements zum Bilden des Steckergehäuses; und Aushärten des Duroplastmaterials.

Ein Vorteil hiervon ist, dass das Verfahren technisch einfach ist. Zudem ist üblicherweise die durch das Verfahren hergestellte Verbindung zwischen dem Steckergehäuse und dem Leiterplattenelement dauerhaft bzw. über einen sehr langen Zeitraum (z.B. mehr als 15 Jahre oder 20 Jahre oder mehr als 25 Jahre) öldicht. Darüber hinaus werden im Allgemeinen für das Verfahren nur ein Werkzeug bzw. eine geringe Anzahl von Werkzeugen benötigt. Insbesondere werden in der Regel keine Stanzwerkzeuge und/oder Vorumspritzwerkzeuge benötigt. Hierdurch sind die Herstellungskosten in der Regel gering.

Ideen zu Ausführungsformen der vorliegenden Erfindung können unter anderem als auf den nachfolgend beschriebenen Gedanken und Erkenntnissen beruhend angesehen werden.

Gemäß der Erfindung umfasst das Leiterplattenelement ein Anschlusselement mit einem Kontaktbereich zum elektrischen Verbinden des Anschlusselements mit dem Verbindungsstecker, ein im Wesentlichen flexibles Zwischenelement und ein Grundelement, wobei das Grundelement über das Zwischenelement mit dem Anschlusselement elektrisch verbunden ist, und das Zwischenelement von dem Duroplastmaterial im Wesentlichen vollständig umschlossen ist. Durch das flexible Zwischenelement ist in der Regel die Orientierung des Anschlusselements bzw. des Steckergehäuses bei der Herstellung des Steckergehäuses technisch einfach an unterschiedliche Gegebenheiten anpassbar. Somit kann die Orientierung bzw. Ausrichtung des Steckergehäuses bzw. der Verbindungssteckeraufnahme bei der Herstellung technisch einfach angepasst bzw. verändert werden. Unter flexibel ist auch ein semi- bzw. teilflexibles Zwischenelement zu verstehen. Das flexible Zwischenelement kann z.B. durch Wegfräsen eines Teils des (starren) Leiterplattenelements der Getriebesteuerungseinrichtung gebildet werden, wodurch das Leiterplattenelement an dieser Stelle dünner und somit (semi-)flexibel wird.

Gemäß der Erfindung weist das Anschlusselement, einen auf seiner Außenoberfläche freiliegenden Kontaktbereich zum elektrischen Verbinden des Leiterplattenelements mit dem Verbindungsstecker auf, und auf dem Kontaktbereich ist teilweise Duroplastmaterial angeordnet. Hierdurch braucht in der Regel bei der Herstellung nicht streng darauf geachtet zu werden, dass kein Duroplastmaterial auf den Kontaktbereich gelangt. Dies vereinfacht in der Regel den Herstellungsprozess.

Gemäß einer Ausführungsform bestehen Oberflächen des Zwischenelements aus dem gleichen Material wie Oberflächen des Grundelements und/oder Anschlusselements. Ein Vorteil hiervon ist, dass das Duroplastmaterial mit allen Teilen des Leiterplattenelements, d.h. Grundelement, Zwischenelement und Anschlusselement, eine stoffschlüssige und folglich dauerhaft bzw. sehr langlebige öldichte Verbindung bildet.

Gemäß einer Ausführungsform umschließt das Steckergehäuse den Kontaktbereich teilweise. Hierdurch wird die Verbindung zwischen Steckergehäuse und Verbindungsstecker in der Regel technisch einfach besonders sicher öldicht abgedichtet.

Gemäß der Erfindung umfasst das Leiterplattenelement ein Anschlusselement, ein im Wesentlichen flexibles Zwischenelement und ein Grundelement, wobei das Grundelement über das Zwischenelement mit dem Anschlusselement elektrisch verbunden ist, und das Duroplastmaterial derart auf einen Teil des Grundelements, einen Teil des Anschlusselements und auf das Zwischenelement aufgebracht wird, dass das Zwischenelement im Wesentlichen vollständig von dem Duroplastmaterial umschlossen ist. Durch das flexible Zwischenelement ist in der Regel die Orientierung des Anschlusselements bzw. des Steckergehäuses bei der Herstellung des Steckergehäuses technisch einfach an unterschiedliche Gegebenheiten anpassbar. Somit kann die Orientierung bzw. Ausrichtung des Steckergehäuses bzw. der Verbindungssteckeraufnahme bei der Herstellung technisch einfach angepasst bzw. verändert werden. Unter flexibel ist auch ein semi- bzw. teilflexibles Zwischenelement zu verstehen. Das flexible Zwischenelement kann z.B. durch Wegfräsen eines Teils des (starren) Leiterplattenelements der Getriebesteuerungseinrichtung gebildet werden, wodurch das Leiterplattenelement an dieser Stelle dünner und somit (semi-)flexibel wird. Gemäß einer Ausführungsform wird das Duroplastmaterial durch Transfermolden und/oder Spritzgießen aufgebracht. Hierdurch kann das Duroplastmaterial in der Regel technisch einfach und kostengünstig aufgebracht werden.

Gemäß der Erfindung wird das Duroplastmaterial teilweise auf einen auf einer Außenoberfläche des Anschlusselements freiliegenden Kontaktbereich, der zum elektrischen Verbinden des Anschlusselements mit dem Verbindungstecker ausgebildet ist, aufgebracht. Ein Vorteil hiervon ist, dass das Duroplastmaterial in der Regel sehr schnell aufgebracht werden kann, da bei der Herstellung nicht darauf geachtet wird, dass kein Duroplastmaterial auf den Kontaktbereich gelangt. Dies vereinfacht in der Regel den Herstellungsprozess.

Gemäß einer Ausführungsform bestehen Oberflächen des Zwischenelements aus dem gleichen Material wie Oberflächen des Grundelements und/oder Anschlusselements. Ein Vorteil hiervon ist, dass das Duroplastmaterial mit allen Teilen des Leiterplattenelements, d.h. Grundelement, Zwischenelement und Anschlusselement, eine stoffschlüssige und folglich dauerhaft bzw. sehr langlebige öldichte Verbindung bildet.

Es wird darauf hingewiesen, dass einige der möglichen Merkmale und Vorteile der Erfindung hierin mit Bezug auf unterschiedliche Ausführungsformen der Getriebesteuerungseinrichtung bzw. des Verfahrens zum Herstellen eines Steckergehäuses beschrieben sind. Ein Fachmann erkennt, dass die Merkmale in geeigneter Weise kombiniert, angepasst oder ausgetauscht werden können, um zu weiteren Ausführungsformen der Erfindung zu gelangen.

### Kurze Beschreibung der Zeichnungen

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind.
- Fig. 1 zeigt: eine Querschnittsansicht einer Ausführungsform der erfindungsgemäßen Getriebesteuerungseinrichtung;
- Fig. 2 zeigt: eine weitere Querschnittsansicht der Getriebesteuerungseinrichtung aus Fig. 1;
- Fig. 3 zeigt: eine Aufsicht auf die Getriebesteuerungseinrichtung aus Fig. 1;
- Fig. 4 zeigt: eine Querschnittsansicht eines Herstellungswerkzeugs zum Herstellen des Steckergehäuses; und
- Fig. 5 zeigt: eine Querschnittsansicht des Herstellungswerkzeugs aus Fig. 4 entlang der Linie V-V.

Die Figuren sind lediglich schematisch und nicht maßstabsgetreu. Gleiche Bezugszeichen bezeichnen in den Figuren gleiche oder gleichwirkende Merkmale.

### Ausführungsformen der Erfindung

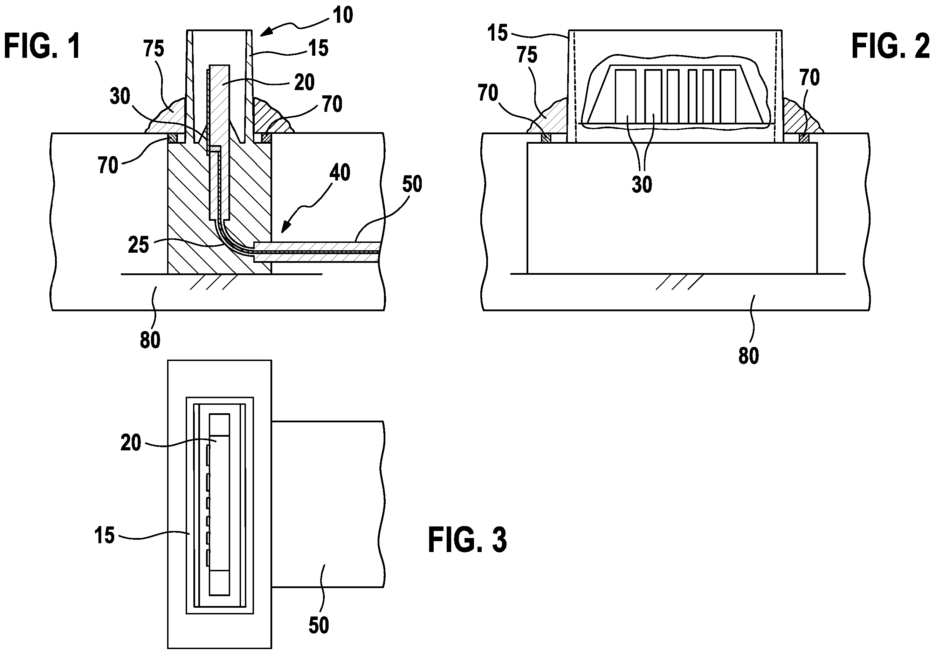

Fig. 1 zeigt eine Querschnittsansicht einer Ausführungsform der erfindungsgemäßen Getriebesteuerungseinrichtung 10. Fig. 2 zeigt eine weitere Querschnittsansicht der Getriebesteuerungseinrichtung 10 aus Fig. 1. Fig. 3 zeigt eine Aufsicht auf die Getriebesteuerungseinrichtung 10 aus Fig. 1.

Die Getriebesteuerungseinrichtung 10 ist in Fig. 1 nur teilweise zu sehen. Die Getriebesteuerungseinrichtung 10 umfasst ein Leiterplattenelement 40. Auf dem Leiterplattenelement 40 sind elektronische Bauelemente angeordnet. Diese sind in den Zeichnungen jedoch nicht dargestellt. Das Leiterplattenelement 40 umfasst ein Grundelement 50, ein Zwischenelement 25 und ein Anschlusselement 20. Das Grundelement 50, das Zwischenelement 25 und das Anschlusselement 20 umfassen in ihrer Mitte jeweils einen oder mehrere elektrische Leiter. Das Zwischenelement 25 verbindet das Grundelement 50 mit dem Anschlusselement 20 elektrisch. Das elektrisch leitende Element ist von dem Grundelement 50 und dem Zwischenelement 25 jeweils vollständig umschlossen.

Das Zwischenelement 25 ist flexibel bzw. biegbar ausgebildet. Hierfür kann ein (in Fig. 1) oberer und unterer Bereich des Leiterplattenelements 40 entfernt worden sein bzw. entfernt werden, um so die Höhe des Zwischenelements 25 zu verringern und dieses biegbar bzw. flexibel zu machen.

Ein Steckergehäuse 15 aus einem duroplastischen Material bzw. Duroplastmaterial ist an dem Leiterplattenelement 40 ausgebildet. Das Duroplastmaterial umschließt das Zwischenelement 25 vollständig und umschließt einen Teil des Grundelements 50 und einen Teil des Anschlusselements 20, der dem Zwischenelement 25 jeweils zugewandt ist. Bei Schwingungsanregung wird das Zwischenelement 25 nur geringfügig mechanisch beansprucht, da dieses vollständig von Duroplastmaterial umgeben ist.

Das Steckergehäuse 15 dient zum Aufnehmen eines Verbindungssteckers, z.B. eines Verbindungssteckers eines Sensors oder eines Stromanschlusses, der mit dem Leiterplattenelement 40 elektrisch verbunden werden soll. Der Verbindungsstecker wird in Fig. 1 von oben nach unten in das Steckergehäuse 15 eingeführt.

Das Anschlusselement 20 weist einen (zum Umgebung hin) freiliegenden Kontaktbereich 30 auf. Der Kontaktbereich 30 verläuft auf der Außenoberfläche des Anschlusselements 20. Ungefähr in der Mitte des Anschlusselements 20 verläuft der elektrische Leiter von der Außenoberfläche des Anschlusselements 20 in das Innere des Anschlusselements 20. In der unteren Hälfte des Anschlusselements 20 verläuft der elektrische Leiter vollständig innerhalb des Anschlusselements 20.

Das einstückige bzw. einteilige Steckergehäuse 15 umgibt den Kontaktbereich 30 und umschließt das Zwischenelement 25 vollständig.

Das Steckergehäuse 15 bildet eine stoffschlüssige öldichte Verbindung mit dem Leiterplattenelement 40. Zwischen dem Steckergehäuse 15 und dem Leiterplattenelement 40 ist kein Kleber oder sonstiges angeordnet. Das Duroplastmaterial ist direkt bzw. unmittelbar auf das Leiterplattenelement 40 aufgebracht. Das Leiterplattenelement 40 kann insbesondere aus einer mit Epoxidharz getränkten Glasfasermatte bestehen (FR4).

Kein Öl dringt somit in den Bereich zwischen dem Steckergehäuse 15 und dem Leiterplattenelement 40 über die gesamte Lebensdauer eines Kraftfahrzeugs (z.B. 15 Jahre, 20 Jahre oder 25 Jahre).

Der Verbindungsstecker weist eine zu dem Aufnahmebereich des Steckergehäuses 15 komplementäre Form auf. Der Verbindungsstecker wird in dem Steckergehäuse 15 derart aufgenommen, dass eine öldichte Verbindung zwischen Verbindungsstecker und Steckergehäuse 15 entsteht. D.h. kein Öl dringt in bzw. durch den Zwischenraum zwischen Verbindungsstecker und Steckergehäuse 15.

In Ausführungsformen, die nicht unter den Wortlaut der Ansprüche fallen, müssen das Zwischenelement 25 und das Anschlusselement 20 nicht zwingend vorhanden sein. Vorstellbar ist auch, dass das Leiterplattenelement 40 nur ein Grundelement 50, welches den Kontaktbereich 30 aufweist. In diesem Fall ist das Steckergehäuse 15 auf dem Grundelement 50 ausgebildet und umschließt einen Teil des Grundelements 50 öldicht.

Das Duroplastmaterial ist teilweise auf dem Kontaktbereich 30 bzw. den Leiterbahnen des Kontaktbereichs 30 angeordnet (siehe Fig. 2). Zumindest ein Teil des Kontaktbereichs 30 bzw. jeder Leiterbahn bzw. jeden elektrischen Leiters des Kontaktbereichs 30 muss freiliegen, damit ein Verbindungsstecker elektrisch mit dem Kontaktbereich 30 verbunden bzw. angeschlossen werden kann.

Das Anschlusselement 20 erstreckt sich mit seiner größten Ausdehnung (Längsrichtung des Anschlusselements 20, in Fig. 1 von oben nach unten) in einem Winkel von ca. 90° zu der Richtung der größten Ausdehnung des Grundelements 50 (Längsrichtung des Grundelements 50, in Fig. 1 von links nach rechts).

Das Steckergehäuse 15 wird auf einer Getriebeplatte 80 bzw. Montageplatte angeordnet bzw. befestigt. Die Aufnahme des Steckergehäuses 15 zum Aufnehmen eines Verbindungssteckers kann einen Winkel von ca. 90° zu der Getriebeplatte 80 aufweisen. Das Steckergehäuse 15 wird in einem Getriebegehäuse 75 angeordnet. Der Zwischenbereich bzw. Zwischenraum zwischen dem Getriebegehäuse 75 und dem Steckergehäuse 15 wird durch eine umlaufende Dichtung 70 (z.B. einer Elastomerdichtung) öldicht abgedichtet. Somit kann auf keinem Wege, weder durch den Bereich zwischen Steckergehäuse 15 und dem Getriebegehäuse 75 noch durch den Bereich zwischen Leiterplattenelement 40 bzw. Anschlusselement 20 und Steckergehäuse 15, Öl in das Getriebegehäuse 75 eindringen. Somit ist die Getriebesteuerungseinrichtung 10 langfristig bzw. über einen sehr langen Zeitraum (z.B. 20 Jahre) öldicht bzw. flüssigkeitsdicht abgedichtet. Dies gilt auch, wenn sich die Getriebesteuerungseinrichtung 10 permanent in einer Ölumgebung befindet.

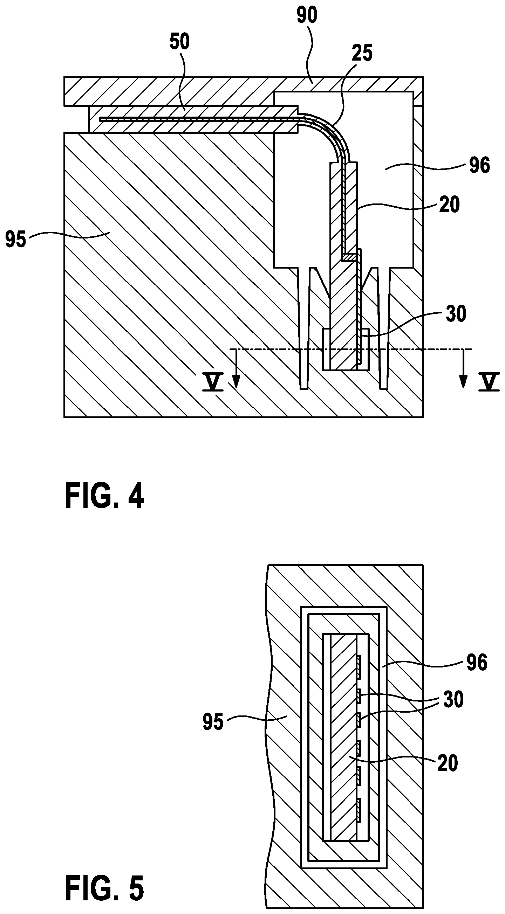

Fig. 4 zeigt eine Querschnittsansicht eines Herstellungswerkzeugs zum Herstellen des Steckergehäuses 15. Fig. 5 zeigt eine Querschnittsansicht des Herstellungswerkzeugs aus Fig. 4 entlang der Linie V-V.

Nachfolgend wird das Verfahren zur Herstellung des Steckergehäuses 15 beschrieben. Das Leiterplattenelement 40 einer Getriebesteuerungseinrichtung 10 wird bereitgestellt. Bei der in Fig. 4 bzw. Fig. 5 gezeigten Ausführungsform umfasst das Leiterplattenelement 40 ein Anschlusselement 20, ein Zwischenelement 25 und ein Grundelement 50. Das Anschlusselement 20 erstreckt sich mit seiner größten Ausdehnung (Längsrichtung des Anschlusselements 20, in Fig. 4 von oben nach unten) in einem Winkel von ca. 90° zu der größten Ausdehnung des Grundelements 50 (Längsrichtung des Grundelements 50, in Fig. 4 von links nach rechts).

Das Leiterplattenelement 40 wird in einem Werkzeug zwischen dem Werkzeugoberteil 90 und dem Werkzeugunterteil 95 eingelegt oder eingeklemmt.

Das Werkzeug weist einen Hohlraum 96 auf, in dem das Zwischenelement 25 und ein Teil des Grundelements 50 sowie ein Teil des Anschlusselements 20 angeordnet wird, der von dem Duroplastmaterial umgeben werden soll.

Der Kontaktbereich 30 weist ein oder mehrere Leiterbahnen auf. Die Leiterbahnen können z.B. aus Kupfer oder eine Kupferlegierung bestehen. Der Bereich zwischen Steckergehäuse und den Leiterbahnen ist öldicht ausgebildet. Kein Öl dringt entlang den Leiterbahnen ein.

Ein Teil des freiliegenden Kontaktbereichs 30 bzw. der Leiterbahnen des Kontaktbereichs 30 ist durch das Werkzeugunterteil gegenüber dem Hohlraum 96 abgedichtet, so dass beim Einbringen von Duroplastmaterial in den Hohlraum 96 kein Duroplastmaterial auf bzw. in diesen Bereich des Kontaktbereichs 30 gelangt. Auch weist das Werkzeugunterteil eine derartige Innenform auf, dass ein Steckergehäuse 15 zum Aufnehmen eines Verbindungssteckers und zum elektrischen Verbinden des Verbindungssteckers mit dem Kontaktbereich 30 beim Ausfüllen des Hohlraums 96 mit einem Duroplastmaterial gebildet wird.

Das Duroplastmaterial wird in den Hohlraum 96 eingefüllt bis der Hohlraum 96 vollständig mit Duroplastmaterial gefüllt ist. Anschließend wird das Duroplastmaterial ausgehärtet. Nun ist das Steckergehäuse 15, wie dies in Fig. 1 bzw. Fig. 2 bzw. Fig. 3 gezeigt ist, ausgebildet. Das ausgebildete Steckergehäuse 15 umschließt das Zwischenelement 25 vollständig. Ebenso umschließt das Steckergehäuse 15 einen Teil des Grundelements 50 und einen Teil des Anschlusselements 20. Folglich wird eine öldichte Verbindung zwischen dem Steckergehäuse 15 und dem Grundplattenelement gebildet. Das Steckergehäuse 15 bildet eine (langlebige) stoffschlüssige öldichte Verbindung mit dem Leiterplattenelement 40. Zwischen dem Steckergehäuse 15 und dem Leiterplattenelement 40 ist kein Kleber oder sonstiges angeordnet. Das Duroplastmaterial wird direkt bzw. unmittelbar auf das Leiterplattenelement 40 aufgebracht.

Das Duroplastmaterial wird durch Transfermolden und/oder Duroplast-Spritzgießen auf das Leiterplattenelement 40 aufgebracht.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Bezugszeichen in den Ansprüchen sind nicht als Einschränkung anzusehen.

## Patentansprüche

1. Getriebesteuerungseinrichtung (10), insbesondere für ein Kraftfahrzeug, wobei die Getriebesteuerungseinrichtung (10) folgendes umfasst:
ein Leiterplattenelement (40) mit elektronischen Bauelementen, und
ein Steckergehäuse (15) zum Aufnehmen eines Verbindungsteckers und zum elektrischen Verbinden des Verbindungsteckers mit dem Leiterplattenelement (40),
wobei das Steckergehäuse (15) im Wesentlichen aus Duroplastmaterial besteht und das Steckergehäuse (15) das Leiterplattenelement (40) in unmittelbarem Kontakt stoffschlüssig teilweise umschließt, wobei das Leiterplattenelement (40) ein Anschlusselement (20) mit einem Kontaktbereich (30) zum elektrischen Verbinden des Anschlusselements (20) mit dem Verbindungsstecker umfasst, wobei das Leiterplattenelement (40) ein im Wesentlichen flexibles Zwischenelement (25) und ein Grundelement (50) umfasst, wobei das Grundelement (50) über das Zwischenelement (25) mit dem Anschlusselement (20) elektrisch verbunden ist, und das Zwischenelement (25) von dem Duroplastmaterial im Wesentlichen vollständig umschlossen ist, **dadurch gekennzeichnet, dass** das Anschlusselement (20) einen auf seiner Außenoberfläche teilweise freiliegenden Kontaktbereich (30) zum elektrischen Verbinden des Leiterplattenelements (40) mit dem Verbindungsstecker aufweist, wobei der Kontaktbereich (30) nach außen zumindest teilweise freiliegende Leiterbahnen aufweist und auf den Leiterbahnen des Kontaktbereichs (30) teilweise das Duroplastmaterial angeordnet ist.

2. Getriebesteuerungseinrichtung (10) nach einem der vorhergehenden Ansprüchen, wobei Oberflächen des Zwischenelements (25) aus dem gleichen Material wie Oberflächen des Grundelements (50) und/oder Anschlusselements (20) bestehen.

3. Getriebesteuerungseinrichtung (10) nach einem der vorhergehenden Ansprüchen, wobei
das Steckergehäuse (15) den Kontaktbereich (30) teilweise umschließt.

4. Verfahren zum Herstellen eines Steckergehäuses (15) an einem Leiterplattenelement (40) einer Getriebesteuerungseinrichtung (10), insbesondere für ein Kraftfahrzeug, wobei das Steckergehäuse (15) zum Aufnehmen eines Verbindungssteckers und zum elektrischen Verbinden des Verbindungsteckers mit dem Leiterplattenelement (40) ausgebildet ist, wobei das Verfahren folgende Schritte umfasst:
Bereitstellen des Leiterplattenelements (40), wobei das Leiterplattenelement ein Anschlusselement (20) aufweist; wobei das Leiterplattenelement (40) ein im Wesentlichen flexibles Zwischenelement (25) und ein Grundelement (50) umfasst, wobei das Grundelement (50) über das Zwischenelement (25) mit dem Anschlusselement (20) elektrisch verbunden ist;
Aufbringen eines Duroplastmaterials auf einen Teil des Grundelements (50),
einen Teil des Anschlusselements (20) und auf das Zwischenelement (25) derart, dass das Zwischenelement (25) im Wesentlichen vollständig von dem Duroplastmaterial umschlossen ist, und
Aushärten des Duroplastmaterials, **dadurch gekennzeichnet, dass** in dem Schritt des Aufbringens das Duroplastmaterial unmittelbar auf das Anschlusselement (20) zum Bilden des Steckergehäuses (15) aufgebracht wird, wobei das Duroplastmaterial teilweise auf einen auf einer Außenoberfläche des Anschlusselements (20) freiliegenden Kontaktbereich (30), der zum elektrischen Verbinden des Anschlusselements (20) mit dem
Verbindungstecker ausgebildet ist und nach außen zumindest teilweise freiliegende Leiterbahnen aufweist, aufgebracht wird, wobei das Duroplastmaterial teilweise auf den Leiterbahnen angeordnet wird.

5. Verfahren nach Anspruch 4, wobei
das Duroplastmaterial durch Transfermolden und/oder Spritzgießen aufgebracht wird.

6. Verfahren nach einem der Ansprüche 4 oder 5, wobei
Oberflächen des Zwischenelements (25) aus dem gleichen Material wie Oberflächen des Grundelements (50) und/oder Anschlusselements (20) bestehen.

## Claims

1. Transmission control device (10), in particular for a motor vehicle,
wherein the transmission control device (10) comprises the following:
a circuit board element (40) having electronic components, and
a plug housing (15) for receiving a connecting plug and for electrically connecting the connecting plug to the circuit board element (40),
wherein the plug housing (15) substantially consists of thermoset material and the plug housing (15) partially encloses the circuit board element (40) with direct contact in an integrally bonded manner, wherein the circuit board element (40) comprises a connection element (20) having a contact region (30) for electrically connecting the connection element (20) to the connecting plug, wherein the circuit board element (40) comprises a substantially flexible intermediate element (25) and a base element (50), wherein the base element (50) is electrically connected to the connection element (20) via the intermediate element (25), and the intermediate element (25) is substantially completely enclosed by the thermoset material, **characterized in that** the connection element (20) has a contact region (30) which is partially exposed on its outer surface and is intended for electrically connecting the circuit board element (40) to the connecting plug, wherein the contact region (30) has conductor tracks which are at least partially exposed to the outside and the thermoset material is partially arranged on the conductor tracks of the contact region (30) .

2. Transmission control device (10) according to one of the preceding claims, wherein surfaces of the intermediate element (25) consist of the same material as surfaces of the base element (50) and/or connection element (20).

3. Transmission control device (10) according to either of the preceding claims, wherein the plug housing (15) partially encloses the contact region (30).

4. Method for producing a plug housing (15) on a circuit board element (40) of a transmission control device (10), in particular for a motor vehicle, wherein the plug housing (15) is designed to receive a connecting plug and to electrically connect the connecting plug to the circuit board element (40), wherein the method comprises the following steps:
providing the circuit board element (40), wherein the circuit board element has a connection element (20);
wherein the circuit board element (40) comprises a substantially flexible intermediate element (25) and a base element (50), wherein the base element (50) is electrically connected to the connection element (20) via the intermediate element (25);
applying a thermoset material to a part of the base element (50), a part of the connection element (20) and to the intermediate element (25) in such a way that the intermediate element (25) is substantially completely enclosed by the thermoset material, and
curing the thermoset material, **characterized in that**, in the application step, the thermoset material is applied directly to the connection element (20) to form the plug housing (15), wherein the thermoset material is partially applied to a contact region (30) which is exposed on an outer surface of the connection element (20) and is designed to electrically connect the connection element (20) to the connecting plug and has conductor tracks which are at least partially exposed to the outside, wherein the thermoset material is partially arranged on the conductor tracks.

5. Method according to Claim 4, wherein the thermoset material is applied by transfer moulding and/or injection moulding.

6. Method according to either of Claims 4 and 5, wherein surfaces of the intermediate element (25) consist of the same material as surfaces of the base element (50) and/or connection element (20).

## Revendications

1. Dispositif de commande de transmission (10), notamment pour un véhicule automobile, le dispositif de commande de transmission (10) comprenant :
un élément carte de circuit imprimé (40) avec des composants électroniques, et
un boîtier de fiche (15) pour recevoir une fiche de connexion et pour connecter électriquement la fiche de connexion à l'élément carte de circuit imprimé (40),
le boîtier de fiche (15) étant essentiellement constitué de matériau thermodurcissable et le boîtier de fiche (15) entourant partiellement l'élément carte de circuit imprimé (40) en contact direct par liaison de matière, l'élément carte de circuit imprimé (40) comprenant un élément de raccordement (20) avec une zone de contact (30) pour connecter électriquement l'élément de raccordement (20) à la fiche de connexion, l'élément carte de circuit imprimé (40) comprenant un élément intermédiaire essentiellement flexible (25) et un élément de base (50), l'élément de base (50) étant connecté électriquement à l'élément de raccordement (20) par le biais de l'élément intermédiaire (25), et l'élément intermédiaire (25) étant essentiellement entièrement entouré par le matériau thermodurcissable, **caractérisé en ce que** l'élément de raccordement (20) présente une zone de contact (30) partiellement exposée sur sa surface extérieure pour connecter électriquement l'élément carte de circuit imprimé (40) à la fiche de connexion, la zone de contact (30) présentant des pistes conductrices au moins partiellement exposées vers l'extérieur et le matériau thermodurcissable étant partiellement agencé sur les pistes conductrices de la zone de contact (30).

2. Dispositif de commande de transmission (10) selon l'une quelconque des revendications précédentes, les surfaces de l'élément intermédiaire (25) étant constituées du même matériau que les surfaces de l'élément de base (50) et/ou de l'élément de raccordement (20) .

3. Dispositif de commande de transmission (10) selon l'une quelconque des revendications précédentes, le boîtier de fiche (15) entourant partiellement la zone de contact (30).

4. Procédé de fabrication d'un boîtier de fiche (15) sur un élément carte de circuit imprimé (40) d'un dispositif de commande de transmission (10), notamment pour un véhicule automobile, le boîtier de fiche (15) étant configuré pour recevoir une fiche de connexion et pour connecter électriquement la fiche de connexion à l'élément carte de circuit imprimé (40), le procédé comprenant les étapes suivantes :
la fourniture de l'élément carte de circuit imprimé (40), l'élément carte de circuit imprimé présentant un élément de raccordement (20) ; l'élément carte de circuit imprimé (40) comprenant un élément intermédiaire essentiellement flexible (25) et un élément de base (50), l'élément de base (50) étant connecté électriquement à l'élément de raccordement (20) par le biais de l'élément intermédiaire (25) ;
l'application d'un matériau thermodurcissable sur une partie de l'élément de base (50), une partie de l'élément de raccordement (20) et sur l'élément intermédiaire (25) de telle sorte que l'élément intermédiaire (25) est essentiellement entièrement entouré par le matériau thermodurcissable, et
le durcissement du matériau thermodurcissable, **caractérisé en ce que,** dans l'étape d'application, le matériau thermodurcissable est appliqué directement sur l'élément de raccordement (20) pour former le boîtier de fiche (15), le matériau thermodurcissable étant partiellement appliqué sur une zone de contact (30) exposée sur une surface extérieure de l'élément de raccordement (20), qui est configurée pour connecter électriquement l'élément de raccordement (20) à la fiche de connexion et qui présente des pistes conductrices au moins partiellement exposées vers l'extérieur, le matériau thermodurcissable étant partiellement agencé sur les pistes conductrices.

5. Procédé selon la revendication 4, le matériau thermodurcissable étant appliqué par moulage par transfert et/ou par moulage par injection.

6. Procédé selon l'une quelconque des revendications 4 ou 5, les surfaces de l'élément intermédiaire (25) étant constituées du même matériau que les surfaces de l'élément de base (50) et/ou de l'élément de raccordement (20) .
